# EUROPÄISCHE PATENTSCHRIFT

(11) **EP 0 840 994 B1**
(45) Veröffentlichungstag und Bekanntmachung des Hinweises auf die Patenterteilung: **11.10.2000**
(21) Anmeldenummer: 96927026.3
(22) Anmeldetag: 17.07.1996
(51) Int. Cl.: H05K 3/42, C25D 5/56

(54) **VERFAHREN ZUR HERSTELLUNG VON DURCHKONTAKTIERTEN LEITERPLATTEN ODER MEHRLAGENLEITERPLATTEN (MULTILAYER)**
PROCESS AND DEVICE FOR PRODUCING THROUGH-CONNECTED PRINTED CIRCUIT BOARDS AND MULTILAYERED PRINTED CIRCUIT BOARDS
PROCEDE DE FABRICATION DE CARTES DE CIRCUITS IMPRIMES ET DE CARTES DE CIRCUITS IMPRIMES MULTICOUCHES A TROUS METALLISES

(30) Priorität: 25.07.1995 DE 19527056
(43) Veröffentlichungstag der Anmeldung: 13.05.1998
(73) Patentinhaber: BLASBERG OBERFLÄCHENTECHNIK GMBH, 42699 Solingen (DE)
(72) Erfinder: HUPE, Jürgen, D-40764 Langenfeld (DE); FIX, Sabine, D-42489 Wülfrath (DE)
(74) Vertreter: Werner, Hans-Karsten, Dr.Dipl.-Chem.
(86) Internationale Anmeldenummer: EP9603134
(87) Internationale Veröffentlichungsnummer: WO9705758

(56) Entgegenhaltungen:
- EP-A- 0 339 341
- EP-A- 0 553 671
- EP-A- 0 707 440
- WO-A-92/20204
- DE-A- 4 040 226

## Beschreibung

Gegenstand der vorliegenden Erfindung ist ein Verfahren zur Herstellung von durchkontaktierten Leiterplatten oder Mehrlagenleiterplatten auf Polymerbasis mit leitfähigen Polymeren mit einem kombinierten Desmear- und Direktmetallisierungsprozeß (Multilayern), bei welchem die mit Bohrlöchern versehenen Basismaterialien auf Polymerbasis einer Reihe von Verfahrensschritten unterworfen werden.

Mehrlagenschaltungen müssen nach dem Bohrprozeß chemisch gereinigt werden, um den sogenannten Smear (Harzverschmierungen, die beim Bohrprozeß auf den Kupferinnenlagen entstehen) von den Innenlagen zu entfernen. Dies ist notwendig, um eine einwandfreie Anbindung der Kupferschicht des späteren Durchkontaktierungsprozesses an die Innenlage zu gewährleisten.

Das Reinigungsverfahren wird auch "Desmear" genannt und erfolgt üblicherweise in einer alkalischen Permanganatlösung, die nach einem vorhergehenden Anquellen des Harzes mit Lösungsmitteln den Smear oxidativ entfernt.

Nach dem "Desmear" schließt sich der Durchkontaktierungsprozeß an, in dessen Verlauf die Bohrlochwandungen mit Kupfer metallisiert werden.

Diese Metallisierung geschieht entweder durch chemische Verkupferung oder durch Direktmetallisierung.

Solche Direktmetallisierungsverfahren sind in vielfältiger Art beschrieben. So gibt es Verfahren, bei denen die Aktivierung der nichtleitenden Bohrlochwandung mittels Pd-Bekeimung erfolgt, oder aber durch eine Belegung mit Kohlenstoffpartikelchen.

In der DE-PS 38 06 884 wird ein Direktmetallisierungsverfahren beschrieben, das zur Erzeugung eines leitfähigen Polymerfilms auf der Bohrlochwandung einen Behandlungsschritt in Permanganat beinhaltet.

Demgemäß sollte es prinzipiell möglich sein, die Bohrlochreinigung und den Durchkontaktierungsprozeß miteinander zu verknüpfen, indem für beide Schritte das gleiche Permanganatbad benutzt wird. Da der beim Permanganatangriff auf dem Harz entstehende Braunstein im Direktmetallisierungsprozeß als Oxidationsmittel bei der Polymerbildung fungiert, kann zusätzlich sogar auf die sonst notwendige Entfernung des Braunsteins im Desmearprozeß (im allgemeinen mit H₂SO₄/H₂O₂) verzichtet werden.

Diese Prozeßabläufe können durch die folgenden Verfahrensschritte beschrieben werden:
I. Desmear-Prozeß
   a) Quellen
   b) Spülen
   c) Alkalisches Permanganat
   d) Spülen
   e) Entfernen der Braunsteinablagerungen
   f) Spülen
   g) Trocknen
II. Direktmetallisierung mittels leitfähigem Polymer
   a) Anätzen
   b) Spülen
   c) Konditionieren
   d) Permanganat
   e) Spülen
   f) Katalysieren mit organischem Monomer
   g) Fixieren (mit Säure)
      Bildung des leitfähigen Polymerfilms
   h) Spülen
   i) Verkupfern
   j) Spülen
   k) Trocknen.

Bereits in der DE-A-39 31 003 wird dieser Gedanke aufgegriffen und führt zu einer vereinfachten Prozeßführung.

Es hat sich jedoch in der praktischen Anwendung solcher vereinfachter Systeme gezeigt, daß bei der Benutzung eines alkalischen Permanganatbades für Desmear mit Durchkontaktierung erhebliche Schwierigkeiten auftreten. Diese sind vor allem darin begründet, daß die Verweilzeiten in einem handelsüblichen Desmear-Permanganat ca. 10 bis 20 min oder bei einer Verfahrensführung im horizontalen Durchlauf ca. 1 bis 2,5 min betragen. Die Expositionszeiten im Permanganat, welches der Bildung einer leitfähigen Polymerschicht dient, betragen erfahrungsgemäß etwa 2 bis 4 min oder 30 bis 60 sec im horizontalen Durchlauf. Um einen ausreichenden Desmeareffekt (Reinigung) zu erzielen, können die oben genannten Zeiten - nicht weiter reduziert werden.

Ferner ist zu beachten, daß die Permanganatlösung zur Bildung des Polymerfilms im allgemeinen im pH-Bereich von 5 bis 9 angewandt wird.

Wird der Arbeitsprozeß wie in DE-A-39 31 003 beschrieben durchgeführt, so sind Durchkontaktierungsfehler wie mangelnde Kupferbedeckung von Harz und bevorzugt Glas des Basismaterials unausweichlich und führen zum Totalausfall der so produzierten Leiterplatte.

In Kenntnis dieser Erfahrungen wird in der DE-A-40 40 226 ein Verfahrensablauf vorgeschlagen, der zwei Permanganatschritte hintereinandergeschaltet enthält, um so die vorgenannten Probleme zu lösen. In der Tat ist es möglich, mit diesem Arbeitsablauf Leiterplatten von guter Qualität zu produzieren.

Dennoch kann auch dieser Prozeß nicht befriedigen, da zwei Behandlungsstufen mit Kaliumpermanganat vorhanden sind, die sehr genau aufeinander abzustimmen sind. Darüber hinaus ist wieder ein erhöhter Platzbedarf vorhanden, und beim Einsatz von Horizontal-Durchlaufanlagen sind zwei sehr teure Anlagenteile notwendig, da ein Einsatz von Edelstahl als zu verarbeitendes Material unumgänglich ist.

Aus der WO 91/08324 sind Verfahren zur Metallisierung von Nichtleitern durch Oxidation von 5-gliedrigen Heterocyclen bekannt. Es wird hierin erwähnt, daß prinzipiell außer Pyrrol auch andere 5-gliedrige Heterocyclen verwendet werden können; vgl. Seite 4, Absatz 3. Alle Ausführungsbeispiele benutzen aber ausschließlich Pyrrol.

Aus der EP 0 339 340 sind neue Polythiophene und ihre Verwendung bekannt, unter anderem auch 3,4-Ethylendioxy-thiophen. Diese Substanzen sollen vor allem zur antistatischen Ausrüstung von den elektrischen Strom nicht oder nur schlecht leitenden Substraten verwendet werden.

Gemäß EP-A-0 553 671 wird das mit Bohrlöchern versehene Basismaterial mit alkalischer Permanganatlösung, Wasser, einer Emulsion von Ethylen-3,4-dioxythiophen, wäßriger Säure und wasser gespült und anschließend galvanisch verkupfert.

Die Erfindung hat sich die Aufgabe gestellt, ein vereinfachtes und dennoch sehr zuverlässiges Verfahren zur Herstellung von durchkontaktierten Leiterplatten zu entwickeln, welches mit nur einem Permanganatschritt auskommt und dennoch zu optimalen Ergebnissen führt.

Überraschenderweise wurde jetzt gefunden, daß ein äußerst einfacher kombinierter Arbeitsgang gemäß DE-A-40 40 226 möglich ist, wenn Ethylen-3,4-dioxythiophen als monomere Ausgangsverbindung eingesetzt wird, die Säure des Fixierschrittes genauestens auf das Monomersystem abgestimmt wird und nach dem Permanganatbehandlungsschritt eine sehr spezielle Spülfolge als Nachbehandlung eingesetzt wird.

Dieses Verfahren ist gekennzeichnet durch die Merkmale des Anspruchs 1. Es kann somit wie folgt beschrieben werden:
1) Quellen in einer an sich bekannten Behandlungsflüssigkeit und Spülen mit Wasser,
2) Behandlung mit einer alkalischen Permanganatlösung,
3) Spülen mit Wasser,
4) Spülen mit saurer, wäßriger Lösung bei einem pH-Wert ca. 1 und einer Spüldauer je nach Säuregehalt 10 bis 120 sek.),
5) Spülen mit Wasser,
6) Spülen mit alkalischer, wäßriger Lösung bei einem pH 8 bis 9,5,
7) Spülen mit Wasser,
8) Spülen mit einer Mikroemulsion von Ethylen-3,4-dioxythiophen,
9) Spülen mit Säure,
10) Spülen mit Wasser,
11) Verkupfern,
12) Spülen mit Wasser und
13) Trocknen.

Danach erfolgt mittels üblicher Prozeßschritte der Leiterbildaufbau.

Mit diesem Verfahren gelingt es, in einem sehr kurzen Prozeß qualitativ einwandfreie und hochwertige Mehrlagenschaltungen herzustellen.

Die überraschende Problemlösung beruht wahrscheinlich darauf, daß der Braunstein, der nach der Permanganatbehandlung auf den Lochwandungen gebildet worden ist, durch die Behandlung mit einer Säurelösung (Schritt 4) oberflächlich so verändert wird, daß die spätere Polymerfilmbildung besser steuerbar und mit einem sehr weiten Arbeitsfenster realisierbar wird. Eine mögliche Erklärung beruht darauf, daß der abgelagerte Braunstein eine nicht fest definierbare Menge Hydroxidium beinhaltet. Diese könnte gegebenenfalls den Polymerisationsschritt in der Anfangsphase verzögern. Zur Vermeidung einer vorzeitigen Polymerisation des an der Oberfläche nun schwach sauren Braunsteins wird nochmals gespült und mit einer sehr schwach alkalischen Lösung (Schritt 6) neutralisiert. Nur durch Anwendung dieser Spülfolge können reproduzierbar gute praktische Ergebnisse erzielt werden.

Weiterhin hat sich gezeigt, daß die bisher vorzugsweise verwendete Monomerlösung auf der Basis von Pyrrol und Lösungsmittel selbst mit der beschriebenen Spülsequenz nicht zu verwertbaren und reproduzierbaren Ergebnissen führt.

Erst durch die Verwendung einer Mikroemulsion von Ethylen-3,4-dioxythiophen auf wäßriger Basis in Kombination mit dem zuvor erwähnten Spülsystem und einer abgestimmten Fixierlösung können einwandfreie Ergebnisse erzielt werden. Äußerst bemerkenswert ist dabei die Tatsache, daß das laterale Kupferwachstum auf dem vergleichsweise angesprochenen Polypyrrolfilm erheblich langsamer ist als auf dem erfindungsgemäß eingesetzten Polyethylendioxythiophenfilm. In grober Näherung kann gesagt werden, daß mit gleichen Kupferelektrolyten (CUPROSTAR LP-1 der Anmelderin) die Kupferabscheidung mit dem Polythiophenfilm etwa zehnmal schneller verläuft als auf dem Polypyrrolfilm. Naturgemäß führt dies zu einer erheblich schnelleren vollständigen Verkupferung der Bohrlochhülse und somit zu einem Qualitätsbonus.

Als Säure in der anschließenden Fixierung wird vorzugsweise Polystyrolsulfonsäure verwendet, aber auch mit anderen Säuren, z.B. H₂So₄, Naphthalin-1,5-disulfonsäure, Dodecylbenzolsulfonsäure, Polyphosphorsäure und Polystyrolsulfonsäure gegebenenfalls mit einem Zusatz von 3,4-Ethylendioxythiophen können gute Ergebnisse erzielt werden.

Das beschriebene Verfahren kann in konventionellen Tauchanlagen ebenso eingesetzt werden wie in horizontalen Durchlaufanlagen.

Gegebenenfalls können auch die Schritte Katalysieren (8) und Fixieren (9) zu einem Schritt zusammengefaßt werden.

### Beispiel 1

Für alle Beispiele wurde glasfaserverstärktes Epoxidharz-Basismaterial (FR-4) verwendet. Das Material war gebohrt und entgratet.
1 Die Substrate wurden einer konventionellen Bohrlochreinigung unterzogen.

| | | | |
|---|---|---|---|
| a) | Quellen (Condisolve ML) | 8 min | 60°C |
| b) | Spülen | | |
| c) | Alkalisches Permanganat (Permaprep MSH) | 8 min | 70°C |
| d) | Spülen | | |
| e) | Neutralisieren (Remover Mn) | 1 min | 20 - 30°C |
| f) | Spülen | | |
| g) | Trocknen | | |

Die so desmearten Materialien wurden in Standard-Direktmetallisierungsprozessen auf Basis leitfähiger Polymere weiterverarbeitet (durchkontaktiert).
1.1 Direktmetallisierungsprozeß "DMS-2" (Pyrrolbasis)

| | | | |
|---|---|---|---|
| a) | Anätzen (BLACID DMA) | 1 min | 30°C |
| b) | Spülen | | |
| c) | Konditionieren (BLASOLIT DMS 2/4) | 2 min | 45°C |
| d) | Spülen | | |
| e) | Kaliumpermanganat (pH 9,5) (wäßrige Lösung) | 2 min | 92°C |
| f) | Spülen | | |
| g) | Katalysieren (Katalysator DMS 2) (Pyrrolbasis) | 1 min | 20 - 25°C |
| h) | Fixieren (Schwefelsäure 180 g/l) | 1 min | 20 - 25°C |
| i) | Spülen | | |
| j) | Verkupfern (CUPROSTAR LP-1) | ca. 60 min I = 2 A/dm² | |
| k) | Spülen | | |
| l) | Trocknen | | |

Die Leiterplatten wurden auf ca. 25 bis 30 µm aufgekupfert. Eine Platte wurde nach 3 min zur Durchführung eines Durchlichttestes entnommen (Ergebnis siehe Tabelle).
Die voll aufgekupferten Platten wurden 10 sec in ein Lotbad von 288°C getaucht, um die Bedingungen des Lötprozesses (thermische Belastung) zu simulieren. Anschließend wurde ein Querschliff angefertigt und die Cu/Cu-Abscheidung an die Innenlage sowie die vollständige Belegung der Bohrlochwandung begutachtet (Ergebnisse siehe Tabelle).
1.2 Direktmetallisierungsprozeß "DMS-E" (3,4-Ethylendioxythiophen-Basis)

| | | | |
|---|---|---|---|
| a) | Anätzen (BLACID DMA) | 1 min | 30°C |
| b) | Spülen | | |
| c) | Konditionieren (BLASOLIT V) | 2 min | 45°C |
| d) | Spülen | | |
| e) | Kaliumpermanganat (pH 9,5) (wäßrige Lösung) | 2 min | 80°C |
| f) | Spülen | | |
| g) | Katalysieren (Catalyst DMS E) (Thiophenbasis, ca. 1 %) | 1 min | 20 - 30°C |
| h) | Fixieren (z.B. Polystyrolsulfonsäure 2,5 %) | 1 min | 20 - 30°C |
| i) | Spülen | | |
| j) | Verkupfern (CUPROSTAR LP-1) | ca. 60 min I = A/dm² | |
| k) | Spülen | | |
| l) | Trocknen | | |

Verarbeitung und Auswertung wie unter 1.1.
2 Die Substrate wurden einem kombinierten Desmear- und Direktmetallisierungsprozeß unterzogen

| | | | |
|---|---|---|---|
| a) | Quellen (Condisolve ML) | 5 min | 60°C |
| b) | Spülen | | |
| c) | Kaliumpermanganat, alkalisch | 5 min | 85°C |

Die Platten wurden nach diesen beiden Schritten diversifiziert und nach unterschiedlichen Arbeitsgängen direkt weiterverarbeitet.
2.1
   d) Spülen
   e) Schritte g) - l) gemäß Beispiel 1.1
2.2
   d) Spülen
   e) Schritte g) - l) gemäß Beispiel 1.1, aber in der Fixierung [Schritt 1.1, h)] wurde 2,5 % wäßrige Lösung von Polystyrolsulfonsäure verwendet.
2.3
   d) Spülen
   e) Schritte g) - l) gemäß Beispiel 1.2
2.4
   d) Spülen
   e) Schritte g) - l) gemäß Beispiel 1.2, aber statt Polystyrolsulfonsäure wurde in der Fixierung (Schritt h) H₂SO₄, 250 g/l, eingesetzt.
2.5
   d) Spülen
   e) Sauer Spülen (ca. pH 1, eingestellt mit H₂SO₄)
   f) Spülen
   g) Alkalisch Spülen (pH 8 bis 9,5, eingestellt mit NaOH)
   h) Spülen

   Die Platten wurden wiederum vereinzelt und unterschiedlich weiterverarbeitet:
   2.5.1 i) Schritt e) gemäß Beispiel 2.1
   2.5.2 i) Schritt e) gemäß Beispiel 2.2
   2.5.3 i) Schritt e) gemäß Beispiel 2.3
   2.5.4 i) Schritt e) gemäß Beispiel 2.4

Die Weiterbehandlung erfolgte wie unter 1.1 beschrieben.

| Ergebnisse | | | | |
|---|---|---|---|---|
| Beispiele | Durchlichttest nach 3 min Verkupferung mit 2 A/dm₂ | Querschliffbeurteilung | | |
| | | Voids | Ring Voids | Cu/Cu-Anbindung |
| 1.1 | d₀ - d₁ | - | - | o.k. |
| 1.2 | d₀ | - | - | o.k. |
| 2.1 | d₃ | 0 - 5 % | - | o.k. |
| 2.2 | d₃ | 0 - 5 % | - | 50 % o.k. |
| 2.3 | 60 % nicht belegt | - | - | o.k. |
| 2.4 | 70 % nicht belegt | - | 20 % | nicht bewertet |
| 2.5.1 | d₂ | - | - | o.k. |
| 2.5.2 | 50 % nicht belegt | - | 0 - 5 % | o.k. |
| 2.5.3 | d₀ | - | - | o.k. |
| 2.5.4 | d₀ - d₁ | - | - | o.k. |

Im Durchlichtest bedeutet d₀ eine vollständige, fehlerfreie Belegung. Die Bewertung d₁ bis d₅ stehen für zunehmend schlechtere und unvollständigere Belegung mit Kupfer. Dazu werden die Prüflinge so aus der Schaltung gesägt, daß das Bohrloch vertikal halbiert wird, wodurch die durchkontaktierte Fläche sichtbar wird. Dann wird die Probe von unten beleuchtet und durch ein Mikroskop betrachtet.

Die Auswertung der Beispiele zeigt deutlich, daß nur mit dem erfindungsgemäßen Arbeitsgang einwandfreie Ergebnisse erzielt werden können. Werden die gleichen Versuche in einer horizontalen Durchlaufanlage durchgeführt, zeigt sich ein gleiches Bild.

Vergleichbar gute Ergebnisse erhält man, wenn man den Schritt h) durchführt mit
. Naphthalin-1,5-disulfonsäure 80 g/l
. Dodecylbenolsulfonsäure 120 g/l
. Polystyrolsulfonsäure 40 g/l + 3,4-Ethylendioxythiophen 0,15 g/l

### Beispiel 2

Gebohrte und entgratete Substrate werden wie folgt behandelt:

| | | | |
|---|---|---|---|
| a) | Quellen (Condisolve ML) | 5 min | 60°C |
| b) | Spülen | | |
| c) | Alkalisches Permanganat | 5 min | 85°C |
| d) | Spülen | | |
| e) | Sauer Spülen (ca. pH 1) | | |
| f) | Spülen | | |
| g) | Alkalisch Spülen (ca. pH 8 bis 9,5) | | |
| h) | Spülen | | |
| i) | Katalysieren, wäßrige Lösung von ca. 0,1 % 3,4-Ethylendioxythiophen und ca. 0,33 % Polystyrolsulfonsäure | 1 min | 20 bis 30°C |
| j) | Spülen | | |
| k) | Verkupfern | | |
| l) | Spülen | | |
| m) | Trocknen | | |

### Beurteilung

| | |
|---|---|
| Durchlichttest | d₀ - d₁ |
| Querschliff | keine Beanstandungen |

Vergleichbar gute Ergebnisse erhält man, wenn der Schritt i) durchgeführt wird mit
. Naphthalin-1,5-disulfonsäure 8 g/l + 3,4-Ethylendioxythiophen 0,2 g/l
. Polyphosphorsäure 20 g/l + 3,4-Ethylendioxythiophen 1 g/l

### Bevorzugte Verfahrensbedingungen für das erfindungsgemäße Verfahren

| | | |
|---|---|---|
| Quellen | 1 bis 10 min | 40 bis 70°C |
| Kaliumpermanganat | 1 bis 10 min | 70 bis 95°C |
| | KMnO₄ | 40 bis 100 g/l |
| | NaOH oder KOH | 10 bis 60 g/1 |
| Saure Spüle | 0,1 bis 200 g/l H₂SO₄ | 10 bis 120 sec |
| Alkalische Spüle | pH 8 bis 9,5 | 10 bis 120 sec |
| Katalysieren | 3,4-Ethylendioxy- | 10 sec bis 5 min |
| | thiophen + Emulgator | 0,1 bis 10 g/l |
| Fixieren | Säure, bevorzugt | 10 sec bis 5 min |
| | Polystyrolsulfonsäure | 0,5 bis 100 g/l |
| | andere Säuren | 5 bis 200 g/l |

## Patentansprüche

1. Verfahren zur Herstellung von durchkontaktierten Leiterplatten oder Mehrlagenleiterplatten auf Polymerbasis mit leitfähigen Polymeren mit einem kombinierten Desmear-und Direktmetallisierungsprozeß, bei welchem die mit Bohrlöchern versehenen Basismaterialien auf Polymerbasis vor dem Leiterbildaufbau folgenden Verfahrensschritten unterworfen werden:
1) Quellen in einer an sich bekannten Behandlungsflüssigkeit und Spülen mit Wasser,
2) Behandlung mit einer alkalischen Permanganatlösung,
3) Spülen mit Wasser,
4) Spülen mit saurer, wäßriger Lösung bei einem pH-Wert ca. 1 und einer Spüldauer je nach Säuregehalt 10 bis 120 sek.,
5) Spülen mit Wasser,
6) Spülen mit alkalischer, wäßriger Lösung bei einem pH 8 bis 9,5,
7) Spülen mit Wasser,
8) Spülen mit einer Mikroemulsion von Ethylen-3,4-dioxy-thiophen,
9) Spülen mit Säure,
10) Spülen mit Wasser,
11) Verkupfern,
12) Spülen mit Wasser und
13) Trocknen

2. Verfahren gemäß Anspruch 1, dadurch gekennzeichnet, daß die Säure in Stufe 4 Schwefelsäure ist in Mengen von 0,1 bis 200 g/l.

3. Verfahren gemäß Anspruch 1 oder 2, dadurch gekennzeichnet, daß das Alkali in Stufe 6 Natronlauge ist.

4. Verfahren gemäß einem der Ansprüche 1 bis 3, dadurch gekennzeichnet, daß die Säure in Stufe 9 Polystyrolsulfonsäure ist in Mengen von 0,5 bis 100 g/l.

5. Verfahren gemäß einem der Ansprüche 1 bis 4, dadurch gekennzeichnet, daß die Schritte 8 und 9 zusammengefaßt werden und mit einem Gemisch aus Ethylen-3,4-dioxythiophen und einer Säure durchgeführt werden.

## Claims

1. A process for producing through-connected printed circuit boards or multilayered printed circuit boards with a polymer base with conductive polymers using a combined desmearing and direct metallization process wherein the polymer base materials, provided with bore holes, are subjected to the following process steps before the conductor pattern is constructed:
1) swelling in a per se known treatment liquid and rinsing with water;
2) treatment with an alkaline permanganate solution;
3) rinsing with water;
4) rinsing with an acidic aqueous solution at a pH value of about 1 and a rinsing time of from 10 to 120 s, depending on the acid content;
5) rinsing with water;
6) rinsing with an alkaline aqueous solution at a pH of from 8 to 9.5;
7) rinsing with water;
8) rinsing with a microemulsion of ethylene-3,4-dioxythiophene;
9) rinsing with acid;
10) rinsing with water;
11) coppering;
12) rinsing with water; and
13) drying.

2. The process according to claim 1, characterized in that the acid in step 4 is sulfuric acid in amounts of from 0.1 to 200 g/l.

3. The process according to claim 1 or 2, characterized in that the alkali in step 6 is aqueous sodium hydroxide.

4. The process according to any of claims 1 to 3, characterized in that the acid in step 9 is polystyrenesulfonic acid in amounts of from 0.5 to 100 g/l.

5. The process according to any of claims 1 to 4, characterized in that steps 8 and 9 are combined and performed with a mixture of ethylene-3,4-dioxythiophene and an acid.

## Revendications

1. Procédé de fabrication de plaquettes conductrices ou de plaquettes conductrices multicouche à trous métallisés à base de polymères, comprenant des polymères conducteurs, au moyen d'un procédé combiné de nettoyage et de métallisation directe, dans lequel les matériaux de base en polymères, pourvus de trous, sont soumis aux étapes de procédé suivantes avant la formation du placage métallique sélectif:
1) gonflement dans un liquide de traitement connu en soi et rinçage à l'eau,
2) traitement avec une solution alcaline de permanganate,
3) rinçage à l'eau,
4) rinçage avec une solution aqueuse acide à une valeur de pH d'environ 1 et une durée de rinçage de 10 à 120 secondes selon la teneur en acide,
5) rinçage à l'eau,
6) rinçage avec une solution aqueuse alcaline à un pH de 8 à 9,5,
7) rinçage à l'eau,
8) rinçage avec une micro-émulsion d'éthylène-3,4-dioxythiophène,
9) rinçage avec un acide,
10) rinçage à l'eau,
11) cuivrage,
12) rinçage à l'eau et
13) séchage.

2. Procédé selon la revendication 1, caractérisé en ce que l'acide, dans l'étape 4, est de l'acide sulfurique en des quantités de 0,1 à 200 g/l.

3. Procédé selon la revendication 1 ou 2, caractérisé en ce que l'alcali, dans l'étape 6, est de la soude caustique.

4. Procédé selon l'une des revendications 1 à 3, caractérisé en ce que l'acide, dans l'étape 9, est de l'acide polystyrènesulfonique en des quantités de 0,5 à 100 g/l.

5. Procédé selon l'une des revendications 1 à 4, caractérisé en ce qu'on combine les étapes 8 et 9 et on les effectue avec un mélange d'éthylène-3,4-dioxythiophène et d'un acide.
